# EUROPEAN PATENT APPLICATION

(11) **EP 2 186 929 A1**
(43) Date of publication of application: **19.05.2010**
(21) Application number: 08778241.3
(22) Date of filing: 17.07.2008
(51) Int. Cl.: C30B 29/06, C30B 15/36

(54) **SEED CRYSTAL FOR PULLING SILICON SINGLE CRYSTAL AND METHOD FOR MANUFACTURING SILICON SINGLE CRYSTAL BY USING THE SEED CRYSTAL**

(30) Priority: 07.09.2007 JP 2007232233
(71) Applicant: SUMCO Corporation, Minato-ku Tokyo 105-8634 (JP)
(72) Inventor: TAKASE, Nobumitsu, Tokyo 105-8634 (JP)
(74) Representative: Albrecht, Thomas
(86) International application number: PCT/JP2008/062899
(87) International publication number: WO 2009/031365

(57) **Abstract**

Provided is a seed crystal for pulling a silicon single crystal that can reduce generation of slip dislocation due to thermal shock that occurs at the time of contact with a silicon melt, suppress propagation of this slip dislocation, and eliminate dislocation even though a diameter of a neck portion is larger than that in conventional examples. The seed crystal for pulling a silicon single crystal according to the present invention is an improvement in a seed crystal used for pulling a silicon single crystal based on a CZ method, and its characteristics configuration lies in that the seed crystal is cut out from a silicon single crystal pulled from a carbon-doped silicon melt and a concentration of carbon with which the seed crystal is doped is in the range of 5×10¹⁵ to 5×10¹⁷ atoms/cm³.

## Description

### TECHNICAL FIELD

The present invention relates to a seed crystal for pulling a silicon single crystal for use in pulling a silicon single crystal based on a Czochralski method (a CZ method) and to a method for manufacturing a silicon single crystal by using the seed crystal.

### BACKGROUND ART

According to a method for manufacturing a silicon single crystal based on the CZ method, a single-crystal silicon is used as a seed crystal and brought into contact with a silicon melt, and then the seed crystal is slowly pulled up while rotating each of a quartz crucible storing the silicon melt and the seed crystal. At this moment, the silicon melt led to this seed crystal is solidified to gradually increase a crystal diameter to a desired diameter, thereby growing a silicon single crystal.

At this time, when the seed crystal is brought into contact with the silicon melt, slip dislocation is produced in the seed crystal at a high density due to thermal shock. When the crystal diameter is increased as it is to grow the silicon seed crystal with this slip dislocation being produced, the dislocation is propagated to a body portion of the grown silicon single crystal. Therefore, such dislocation must be completely eliminated so that it is not generated in the silicon single crystal to be pulled.

As a countermeasure, to annihilate the dislocation propagated from the slip dislocation, there is adopted a so-called Dash's neck method for realizing a dislocation-free state by reducing a diameter of the crystal that is grown from the seed crystal immediately after start of pulling to approximately 3 mm to form a neck portion, and then increasing the crystal diameter to a predetermined diameter to form a shoulder portion, thereby growing a single crystal having a fixed diameter. It is to be noted that, in the general Dash's neck method, when a diameter of the neck portion to be formed exceeds 5 mm, the dislocation is hard to shift out of the crystal and all the dislocations generated at a high density do not shift out of the crystal, whereby realizing the dislocation-free state is difficult.

However, with a recent increase in a silicon single crystal diameter, strength of a neck portion formed based on the conventional Dash's neck method is insufficient to support a silicon single crystal having an increased weight, and there is a concern that this narrow neck may be fractured during pulling of the single crystal and a serious accident, e.g., fall of the single crystal may occur.

As a measure for solving such a problem, increasing a diameter of the neck portion where the dislocation can be eliminated by applying a magnetic field or scheming a shape or an arrangement position of a heat shielding member is suggested.

Further, there is disclosed a technology for increasing strength of a seed crystal and reducing the slip dislocation generated at the time of seeding by doping a boron to the seed crystal at a high concentration of 1×10¹⁹ cm⁻³ or above (see, e.g., Patent Document 1).

Furthermore, there is disclosed a seed crystal for pulling a silicon single crystal that is a seed crystal for use in pulling a silicon single crystal based on the CZ method, wherein an end portion coming into contact with a silicon melt is coated with a carbon film (see, e.g., Patent Document 2).
Patent Document 1: Japanese Patent Application Laid-open No. 139092-1992 (claim [1], 11. 12-14 in a lower right column in p. 3, and 11. 16-18 in an upper left column in p. 4)
Patent Document 2: Japanese Patent Application Laid-open No. 2005-272240 (claim 5, and FIG. 2)

### DISCLOSURE OF INVENTION

### PROBLEM TO BE SOLVED BY THE INVENTION

However, according to such a method using a seed crystal doped with boron at a high concentration as disclosed in Patent Document 1, since a material called boron that changes a resistivity of a crystal is used for the seed crystal, there is a problem that a resistivity of a pulled silicon single crystal deviates from a desired numeric value. That is because boron in the seed crystal enters a silicon melt to function as a dopant that changes the resistivity. Therefore, there is a drawback that the method cannot be used for purposes except growth of a crystal having a low resistivity. Moreover, when any unintentional accident or the like occurs to generate dislocation in a single crystal that is being pulled, since a seed crystal is disconnected from the single crystal to again melt the single crystal in the silicon melt and then the disconnected seed crystal is again brought into contact with the silicon melt to perform re-pulling or another seed crystal is utilized to perform re-pulling but the seed crystal is molten and then pulled in the re-pulling process, a melting amount is increased and boron enters the silicon melt beyond necessity, and hence there occurs an inconvenience that a resistivity of the silicon single crystal to be re-pulled deviates from an originally planned rate.

Additionally, it can be considered that such a seed crystal coated with a carbon film at an end portion coming into contact with a silicon melt as disclosed in Patent Document 2 is intended to reduce a temperature difference between the silicon melt and the seed crystal to decrease thermal shock dislocation when the carbon film absorbs radiant heat from the silicon melt or other members in a pulling apparatus to increase a temperature at the end portion. However, it is inferred that an unmelted portion is produced to facilitate generation of dislocation when such a seed crystal is used.

It is an object of the present invention to provide a seed crystal for pulling a silicon single crystal that can reduce generation of slip dislocation due to thermal shock that occurs at the time of contact with a silicon melt, suppress propagation of this slip dislocation, and eliminate the dislocation even though a diameter of a neck portion is larger than a diameter in the conventional example, and also provide a method for manufacturing a silicon single crystal by using the seed crystal.

### MEANS FOR SOLVING PROBLEM

A first aspect of the present invention is an improvement in a seed crystal for use in pulling a silicon single crystal based on the CZ method. Its characteristic configuration lies in that the seed crystal is cut out from a silicon single crystal pulled from a silicon melt doped with carbon and a concentration of the carbon with which the seed crystal is doped is in the range of 5×10¹⁵ to 5×10¹⁷ atoms/cm³.

In the first aspect of the present invention, carbon with which the seed crystal is doped can reduce generation of the slip dislocation due to thermal shock that occurs at the time of contact with the silicon melt and can suppress propagation of this slip dislocation, thereby realizing a dislocation-free state even though a diameter of the neck portion is larger than that in the conventional example. Therefore, the silicon single crystal having a large weight can be pulled up.

According to a second aspect of the present invention, there is provided the seed crystal, wherein a concentration of oxygen in the seed crystal is in the range of 1×10¹⁸ to 2×10¹⁸ atoms/cm³.

In the second aspect of the present invention, if the concentration of oxygen in the seed crystal falls within the above-described range, an effect of forming fine precipitation nuclei is increased.

According to a third aspect of the present invention, there is provided the seed crystal, wherein the seed crystal is cut out from a silicon single crystal pulled from a silicon melt doped with nitrogen besides carbon, and a concentration of the nitrogen is in the range of 5×10¹³ to 5×10¹⁵ atoms/cm³.

In the third aspect of the present invention, the seed crystal further contains nitrogen in the above-described concentration range, thereby increasing the effect of forming fine precipitation nuclei.

A fourth aspect of the present invention is an improvement in a method for manufacturing a silicon single crystal by which a silicon melt led to a seed crystal is pulled based on the CZ method to grow a silicon single crystal. Its characteristic configuration lies in that the seed crystal is cut out from a silicon single crystal pulled from a silicon melt doped with carbon and a concentration of the carbon with which the seed crystal is doped is a range of 5×10¹⁵ to 5×10¹⁷ atoms/cm³.

In the fourth aspect of the present invention, since carbon with which the seed crystal is doped can suppress propagation of slip dislocation due to thermal shock that occurs at the time of contact with the silicon melt, a dislocation-free state can be realized even though a diameter of a neck portion is larger than a diameter in the conventional example. Therefore, the silicon single crystal having a large weight can be pulled up.

According to a fifth aspect of the present invention, there is provided the method for manufacturing a silicon single crystal, wherein a concentration of oxygen in the seed crystal is in the range of 1×10¹⁸ to 2×10¹⁸ atoms/cm³.

In the fifth aspect of the present invention, when the concentration of oxygen in the seed crystal falls within the above-described range, the effect of forming fine precipitation nuclei can be increased.

According to a sixth aspect of the present invention, there is provided the method for manufacturing a silicon single crystal, wherein the seed crystal is cut out from a silicon single crystal pulled from a silicon melt doped with nitrogen besides carbon and a concentration of the nitrogen is in the range of 5×10¹³ to 5×10¹⁵ atoms/cm³.

In the sixth aspect of the present invention, when the seed crystal further contains nitrogen in the above-described concentration range, the effect of forming fine precipitation nuclei can be increased.

### EFFECT OF THE INVENTION

In the seed crystal for pulling a silicon single crystal and the method for manufacturing a silicon single crystal by using the seed crystal according to the present invention, since carbon with which the seed crystal is doped can reduce generation of slip dislocation due to thermal shock that occurs at the time of contact with the silicon melt and suppress propagation of this slip dislocation, a dislocation-free state can be realized even though a diameter of the neck portion is larger than a diameter in the conventional example. Therefore, the silicon single crystal having a large weight can be pulled up.

### BRIEF DESCRIPTION OF DRAWINGS

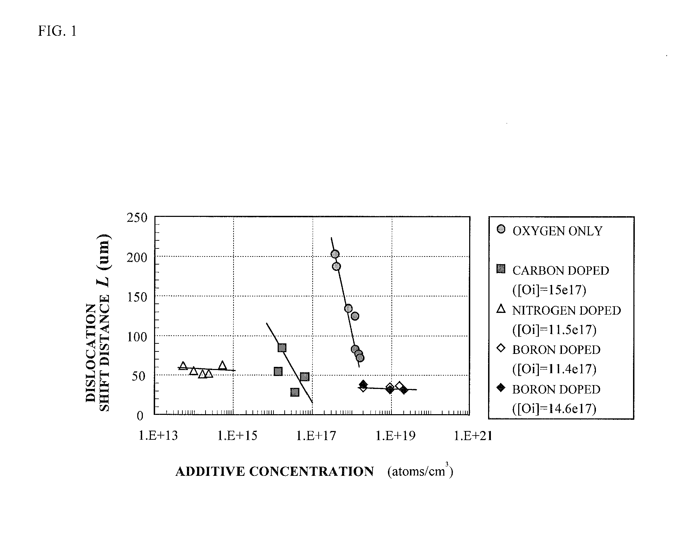

FIG. 1 is a view showing a relationship between a concentration of each element in a seed crystal and a dislocation shift distance L when a silicon single crystal is pulled by using the seed crystal doped with each element.

### BEST MODE(S) FOR CARRYING OUT THE INVENTION

The best mode for carrying out the present invention will now be described with reference to the drawings.

A seed crystal for pulling a silicon single crystal according to the present invention is an improvement in a seed crystal used for pulling a silicon single crystal based on the CZ method. The seed crystal according to the present invention is cut out from a silicon single crystal pulled from a silicon melt doped with carbon, and it is characterized in that a concentration of the carbon with which the seed crystal is doped is in the range of 5×10¹⁵ to 5×10¹⁷ atoms/cm³. The seed crystal doped with carbon in the above-described concentration range can reduce generation of slip dislocation due to thermal shock that occurs at the time of contact with the silicon melt and can suppress propagation of this slip dislocation.

FIG. 1 shows a dislocation shift distance L in a neck portion when a silicon single crystal is pulled by using each of seed crystals having respective elements, i.e., oxygen, carbon, nitride, and boron added therein. It is to be noted that [Oi] in FIG. 1 represents an oxygen concentration contained in each seed crystal.

The dislocation shift distance L in FIG. 1 was calculated as follows. First, a wafer having a desired element added therein was prepared, and it was sliced out with a size of approximately 10 cm × 5 cm to be determined as a measurement sample. A Vickers hardness tester was utilized to introduce an indentation to a surface of this measurement sample by holding this surface for 10 seconds with a load of 100 g. Subsequently, the measurement sample was subjected to a heat treatment at 900°C for 30 minutes. A measurement surface of the measurement sample having the indentation introduced thereto after the heat treatment was subjected to preferential etching for 3 µm by using a Write etchant to measure the dislocation shift distance L on a wafer cross section.

It is to be noted that the following method may be used for confirming an actual effect. First, the seed crystal is brought into contact with the silicon melt to melt a liquid accretion portion, then the seed crystal is slowly pulled up while rotating each of a quartz crucible storing the silicon melt and the seed crystal to form a neck portion, and pulling is stopped. Then, the silicon single crystal is taken out from a pulling apparatus, then a crystal growing portion including a liquid accretion interface of the seed crystal is sliced out with a thickness of 1.0 to 2.0 mm, and this is determined as a measurement sample. A (110) vertical cross section of this measurement sample is determined as a measurement surface, and etching is carried out with a mixture containing a mixed acid (hydrofluoric acid : nitric acid = 1:4). Then, an X-ray topographic observation apparatus is utilized to evaluate a presence state of internal dislocation based on (220) plane transmission.

As apparent from FIG. 1, paying attention to the shift distance L of the dislocation generated in the neck portion when pulled by using the seed crystal having each element added therein, a tendency that the shift distance L is reduced as concentrations of oxygen and carbon rise can be seen. Further, the dislocation shift distance L hardly changes even though nitrogen or boron is added with an increased concentration. Among others, when nitrogen alone is used as a dopant, the dislocation shift distance L is approximately 50 mm, and the shift distance cannot be sufficiently suppressed. Further, the dislocation shift distance L is approximately 70 mm even though oxygen is contained at a high concentration, and the shift distance cannot be sufficiently suppressed in this case. When boron alone is used as a dopant, the dislocation shift distance L is 30 to 40 mm, and the shift distance can be suppressed, but boron functions as a material that changes a resistivity as described above, and hence there is a problem that this dopant cannot be used for purposes other than crystal growth having a low resistivity. On the other hand, when carbon is a dopant, the dislocation shift distance L is reduced as a concentration rises, and there can be observed an excellent effect that the shift distance can be suppressed to the same level as that of boron that is well known in the conventional examples.

Furthermore, considering a pinning effect of dislocation when the seed crystal is doped with carbon, carbon atoms themselves have the pinning effect and, on the other hand, carbon atoms also have an effect of forming fine precipitation nuclei. Therefore, they have an effect of further blocking movement of dislocation by the formed fine precipitation nuclei as compared with other elements. Therefore, carbon is superior to other elements such as boron in terms of the pinning effect.

Moreover, the seed crystal doped with carbon has an excellent effect that the resistivity of the pulled silicon single crystal is not changed different from boron even though carbon enters the silicon melt due to melting of the seed crystal.

The seed crystal according to the present invention is cut out from the silicon single crystal pulled from the silicon melt doped with carbon. For example, when a carbon layer or the like is provided on a surface layer of a single silicon crystal that is not doped with carbon to provide a seed crystal, it can be considered that the carbon layer provided on the surface layer can suppress generation of slip dislocation due to thermal shock at a given rate, but it is inferred that propagation of the generated slip dislocation cannot be suppressed after the seed crystal is brought into contact with the silicon melt to be melted since carbon is present in the surface layer of the seed crystal alone. Additionally, as described above, since the seed crystal has a configuration that the carbon layer is provided on the surface layer of the silicon crystal, it can be considered that uniform melting cannot be realized or an unmelted portion is produced to readily generate dislocation. Further, there can be considered an inconvenience that the carbon layer is delaminated from the surface layer of the seed crystal due to a difference in thermal expansion between silicon and the carbon layer, this layer falls into the silicon melt, and this turns to dust to generate dislocation in the single crystal during growth.

On the other hand, like the present invention, if the seed crystal that is pulled from the carbon-doped silicon melt and cut out from the silicon single crystal in a state that carbon is present in the silicon crystal structure is used, an unmelted portion is not produced when the seed crystal comes into contact with the silicon melt, and slip dislocation due to thermal shock can be suppressed.

In regard to carbon, like other dopants, an impurity concentration of a liquid phase is different from that of a solid phase due to a phenomenon called segregation, and the liquid phase has a higher concentration. The silicon single crystal pulled from the carbon-doped silicon melt has a concentration that is not fixed in a growth axis direction. That is because a carbon concentration in the silicon melt increases as a solidification rate rises due to the segregation phenomenon, and hence a concentration of carbon contained in the silicon single crystal to be pulled also increases. Therefore, a top portion and a bottom portion of the pulled silicon single crystal has different concentrations of carbon used for doping, and the top portion has a lower concentration while the bottom portion has a higher concentration.

Furthermore, the seed crystal to be cut out is cut out in such a manner that a growth direction of the carbon-doped silicon single crystal becomes a longitudinal direction based on a relationship of crystal orientation. Therefore, in the seed crystal according to the present invention, the top portion and the bottom portion have different carbon concentrations, and a concentration in the top portion is low while a concentration in the bottom portion is high.

The concentration of carbon used for doping in the seed crystal according to the present invention is set to fall within the above-described range because propagation of slip dislocation due to thermal shock is not sufficiently suppressed when the carbon concentration is less than a lower limit value, a dislocation-free crystal cannot be grown with a diameter larger than a diameter of a neck portion in the conventional example, and fabricating a carbon-doped seed crystal having a concentration exceeding an upper limit value is technically difficult. Among others, a range of 5×10¹⁶ to 5×10¹⁷ atoms/cm³ is particularly preferable.

Further, in regard to the fine precipitation nuclei formed by the carbon doping, when an oxygen concentration in the seed crystal is set to a predetermined concentration, carbon is coupled with oxygen to form further fine precipitation nuclei, thereby increasing the number of precipitation nuclei.

As a concentration of oxygen in the seed crystal, the range of 1 to 2×10¹⁸ atoms/cm³ is preferable. A synergetic effect of the carbon doping cannot be obtained when the concentration is less than a lower limit value, and fabrication is difficult and an inconvenience of precipitation excess occurs when the concentration exceeds an upper limit value. Among others, the range of 1.1 to 1.6×10¹⁸ atoms/cm³ is particularly preferable.

Furthermore, the fine precipitation nuclei formed by the carbon doping can be increased by doping the seed crystal with nitrogen besides carbon. Although the precipitation nuclei can be formed by doping the single crystal with carbon alone, each precipitation nucleus formed in this case becomes a large nucleus, and hence a dislocation propagation suppressing effect is poor. On the other hand, when doping with both carbon and nitrogen is carried out, each formed precipitation nucleus becomes a finer nucleus than that formed by doping the single crystal with nitrogen alone, and more fine precipitation nuclei can be formed as compared with a case that the single crystal is doped with carbon alone. The seed crystal doped with nitrogen is obtained by cutting from the silicon single crystal pulled from the silicon melt doped with nitrogen. In this case, since doping with both carbon and nitrogen is carried out, each concentration in the silicon melt must be adjusted in advance in such a manner that each concentration in the pulled silicon single crystal becomes a desired concentration while considering each segregation coefficient.

As a concentration when further adding nitrogen to the seed crystal, the range of 5×10¹³ to 5×10¹⁵ atoms/cm³ is preferable. A synergetic effect of the carbon doping cannot be obtained when the concentration is less than a lower limit value, and the concentration approximates a solid solubility limit and fabrication is difficult when the concentration exceeds an upper limit. Among others, the range of 5×10¹³ to 5×10¹⁴ atoms/cm³ is particularly preferable.

Based on these characteristics, when the seed crystal according to the present invention is utilized to pull the silicon single crystal, since generation of slip dislocation due to thermal shock that occurs at the time of contact with the silicon melt can be reduced and propagation of this slip dislocation can be suppressed, a dislocation-free state can be realized even though a diameter of the neck portion is larger than that in the conventional example. Therefore, the silicon single crystal having a large weight can be pulled up.

It is to be noted that, even if the seed crystal doped with carbon having a concentration of 10¹⁷ atoms/cm³ order close to an upper limit value in the present invention is used, since this concentration is reduced by the silicon melt and carbon has a segregation phenomenon, the concentration of carbon contained in the actually pulled silicon single crystal hardly varies as compared with a situation where a conventional seed crystal that is not doped with carbon is utilized to perform pulling, and hence it can be said that carbon does not affect a device.

Moreover, although not specified in this embodiment, the seed crystal according to the present invention having the same shape as that of a conventionally known seed crystal can be used.

### INDUSTRIAL APPLICABILITY

According to the seed crystal for puling a silicon single crystal of the present invention, a dislocation-free state can be realized even though a diameter of the neck portion is larger than that in the conventional example, and hence this seed crystal can be applied to pulling a silicon single crystal having a large weight.

## Claims

1. A seed crystal being used for pulling a silicon single crystal based on a Czochralski method,
wherein the seed crystal is cut out from a silicon single crystal pulled from a silicon melt doped with carbon, and
a concentration of the carbon with which the seed crystal is doped is in the range of 5×10¹⁵ to 5×10¹⁷ atoms/cm³.

2. The seed crystal according to claim 1, wherein a concentration of oxygen in the seed crystal is in the range of 1×10¹⁸ to 2×10¹⁸ atoms/cm³.

3. The seed crystal according to claim 1, wherein the seed crystal is cut out from a silicon single crystal pulled from a silicon melt doped with nitrogen besides carbon, and
a concentration of the nitrogen is in the range of 5×10¹³ to 5×10¹⁵ atoms/cm³.

4. A method for manufacturing a silicon single crystal as a method for manufacturing a silicon single crystal that grows the silicon single crystal by pulling a silicon melt led to a seed crystal based on a Czochralski method,
wherein the seed crystal is cut out from a silicon single crystal pulled from a silicon melt doped with carbon, and a concentration of the carbon with which the seed crystal is doped is in the range of 5×10¹⁵ to 5×10¹⁷ atoms/cm³.

5. The method for manufacturing a silicon single crystal according to claim 4, wherein a concentration of oxygen in the seed crystal is in the range of 1×10¹⁸ to 2×10¹⁸ atoms/cm³.

6. The method for manufacturing a silicon single crystal according to claim 4, wherein the seed crystal is cut out from a silicon single crystal pulled from a silicon melt doped with nitrogen besides carbon, and a concentration of the nitrogen is in the range of 5×10¹³ to 5×10¹⁵ atoms/cm³.
